# FASCICULE DE BREVET EUROPEEN

(11) **EP 1 213 839 B1**
(45) Date de publication et mention de la délivrance du brevet: **20.04.2005**
(21) Numéro de dépôt: 01403055.5
(22) Date de dépôt: 29.11.2001
(51) Int. Cl.: H03L 7/081

(54) **Procédé pour déterminer un ordre de cellules à retarder dans une chaîne de N cellules**
Verfahren zur Bestimmung eines Reihenfolges von Verzögerungszellen in einer N-Zellenkette
Method for determining an order in cells to be delayed in a chain of N cells

(30) Priorité: 07.12.2000 FR 0015856
(43) Date de publication de la demande: 12.06.2002
(73) Titulaire: BULL S.A., 78430 Louveciennes (FR)
(72) Inventeur: Boudry, Jean-Marie, 78650 Beynes (FR)

(56) Documents cités:
- EP-A- 0 608 972
- FR-A- 2 658 015
- US-A- 5 422 835

## Description

L'invention se rapporte à un circuit multiplieur de fronts. Un tel circuit est utile par exemple pour obtenir plusieurs signaux d'horloge déphasés à partir d'un même signal d'horloge de référence. Un tel circuit est aussi utile pour obtenir un signal d'horloge de fréquence supérieure à un signal d'horloge de référence.

Le brevet d'invention FR2658015 (US5260608, US5548235 et US5838178 aux Etats Unis) décrit un circuit verrouillé en phase permettant de réaliser un multiplieur de fréquence. En comparaison des circuits connus de type VCO, commandés en tension, ce circuit présente l'avantage d'un temps de réponse court et une bonne immunité aux bruits. Un circuit à retard y est commandé par le signal de sortie d'un comparateur de phase entre le signal d'entrée et le signal de sortie du circuit à retard. Le circuit à retard y est constitué d'un nombre N de cellules en cascade tel que le signal de commande pilote un incrément de retard élémentaire Te de chaque cellule. Le signal de commande attaquant simultanément les N cellules, l'incrément de retard minimal du circuit à retard est égal à N fois l'incrément de retard élémentaire Tₑ de chaque cellule. Le circuit à retard de cet état de la technique permet de corriger une erreur de phase entre son entrée et sa sortie au mieux avec une précision de N fois Tₑ.

Un circuit similaire est aussi décrit dans le brevet d'invention US5422835.

Un objectif de la présente invention est de corriger une erreur de phase entre l'entrée et la sortie d'un circuit à retard avec une meilleure précision que N fois Te. Ceci présente un avantage pour atteindre des fréquences élevées alors que la valeur minimale d'un incrément de retard élémentaire Tₑ est nécessairement limitée par la technologie de réalisation du circuit. Selon une solution de la présente invention, le signal de sortie du comparateur de phase ne commande pas simultanément les N cellules mais séparément chaque cellule.

La solution proposée n'est pas évidente car une commande simultanée de toutes les cellules garantie un maintien du rapport cyclique (duty cycle en anglais) du signal. En effet, on remarque sur un circuit à retard de l'état de la technique que l'incrémentation du retard d'une seule cellule à la fois pose problème. Pour une erreur de phase de Te, avant correction, le signal de sortie de chaque cellule est en erreur de phase de n fois Te/N par rapport à la phase idéale, n variant de 1 pour la première cellule en entrée du circuit à retard, à N pour la dernière cellule en sortie du circuit à retard.

Une commande d'incrémentation successive de chaque cellule dans l'ordre de cascade n'est pas satisfaisante. Une correction de Te sur la première cellule provoque une erreur de phase égale à (N-1)Te/N par rapport à la phase idéale puis une erreur de phase égale à (N-n)Te/N sur chaque cellule jusqu'à la dernière pour laquelle l'erreur de phase égale à (N-N)Te/N est alors nulle. Dans un multiplieur de fréquence où sont combinés les signaux de sortie de tout ou partie des cellules, ceci peut avoir pour conséquence de modifier le rapport cyclique de (N-1)Te/N. L'erreur de phase se retrouve dans l'obtention d'un signal d'horloge déphasé à partir d'une n^{ième} cellule. Le phénomène est encore amplifié pour une erreur de phase sur l'ensemble du circuit à retard, supérieure à Te.

Une commande d'incrémentation successive de chaque cellule dans l'ordre inverse de cascade n'est pas plus satisfaisante. Commencer à partir de la cellule médiane du circuit à retard reporte le problème sur le groupe de cellules précédentes et le groupe de cellules suivantes en y ajoutant un problème de choix sur le groupe de cellules à retenir pour une correction ultérieure.

Le but de l'invention est de réaliser un circuit multiplieur de fronts au moyen d'un circuit à retard constitué de cellules connectées en cascade, rebouclé en phase sur son entrée, et ceci en évitant les inconvénients précédemment mentionnés de l'état de la technique.

L'objet de l'invention est un procédé pour déterminer un ordre de cellules à retarder dans une chaîne de N cellules à retard, rebouclée en phase. Le procédé comprend:
- une première boucle d'actions pour des valeurs j variant de 1 à N, chacune correspondante à un retard total égal à j fois un retard élémentaire d'une cellule, à appliquer à la chaîne de N cellules à retard, une action de la première boucle comprenant:

- une deuxième boucle d'actions pour des valeurs i variant de 1 à N, chacune correspondante à un rang de cellule de ladite chaîne, une action de la deuxième boucle calculant une erreur de retard en sortie de la cellule de rang i par rapport à un retard idéal qui équirépartit le retard total de la chaîne sur chaque cellule, de façon à ce que:

- une première valeur de ladite erreur est calculée avant commande d'un retard élémentaire supplémentaire de la cellule de rang i;
- une deuxième valeur de ladite erreur est calculée si la première valeur est supérieure à un seuil prédéterminé, après commande d'un retard élémentaire supplémentaire de ladite cellule de rang i, ledit rang i complétant alors ledit ordre à déterminer.

L'ordre déterminé par le procédé conforme à l'invention, permet de réaliser un circuit multiplieur de fronts dans lequel un retard élémentaire supplémentaire est appliqué progressivement à une nouvelle cellule selon l'ordre déterminé, de sorte à minimiser l'erreur en sortie de chaque cellule, par rapport à un retard idéal réparti de façon équitable entre toutes les cellules. La mise en oeuvre du procédé pour des valeurs de N variant de 3 à 20 et au delà a permis d'observer une erreur maximale équivalente au retard élémentaire.

Les caractéristiques et avantages de l'invention ressortent de la description qui suit, donnée à titre d'illustration et faite en référence aux dessins annexés.

Dans les dessins:
- la figure 1 illustre schématiquement un circuit verrouillé en phase conforme à l'invention;
- la figure 2 illustre schématiquement une cellule à retard conforme à l'invention;
- la figure 3 illustre un détail supplémentaire de cellule à retard conforme à l'invention;
- la figure 4 montre un exemple de mise en oeuvre du procédé conforme à l'invention;
- les figures 5 et 6 montrent des raffinements du procédé conforme à l'invention;
- la figure 7 illustre un circuit combinatoire pour une valeur particulière du nombre de cellules.

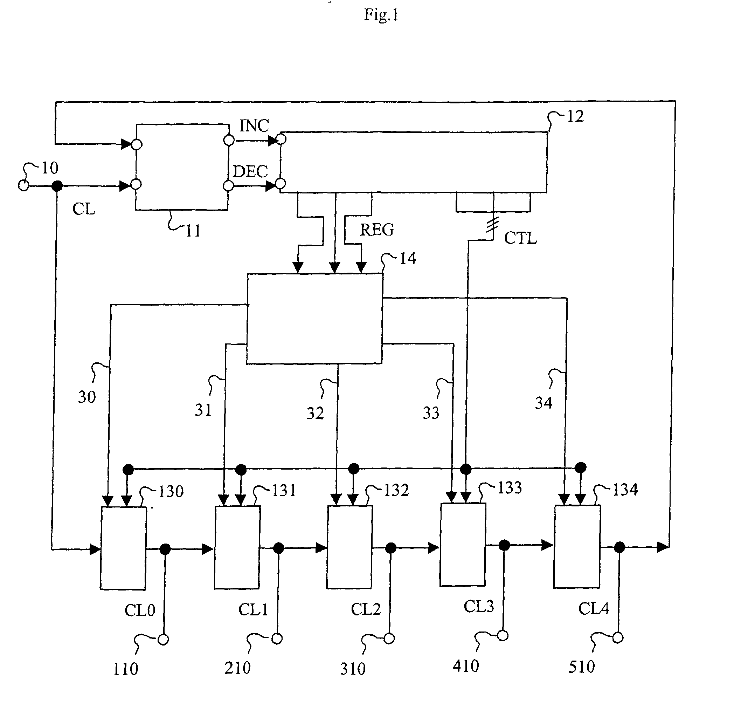

En référence à la figure 1, un nombre N de cellules à retard 130, 131, 132, 133, 134, sont connectées en cascade de telle sorte que la cellule 130 reçoit en entrée un signal oscillant CL pour générer en sortie un signal oscillant CL0, la cellule 131 reçoit en entrée le signal oscillant CL0 pour générer en sortie un signal oscillant CL1, la cellule 132 reçoit en entrée le signal oscillant CL1 pour générer en sortie un signal oscillant CL2, la cellule 133 reçoit en entrée le signal oscillant CL2 pour générer en sortie un signal oscillant CL3, la cellule 134 reçoit en entrée le signal oscillant CL3 pour générer en sortie un signal oscillant CL4. Chaque signal est généré en sortie de la cellule avec une fréquence identique à celle du signal reçu en entrée et avec un retard propre à chaque cellule. Le retard ainsi cumulé des cellules 130,...,134 provoque un déphasage du signal CL4 sur le signal CL.

La phase du signal CL4 est comparée à la phase du signal CL dans un comparateur de phase 11 connu à résultat binaire : avance ou retard de phase. Lorsque la phase du signal CL4 est inférieure à la phase du signal CL, le comparateur de phase 11 génère un signal INC. Lorsque la phase du signal CL4 est supérieure à la phase du signal CL, le comparateur de phase 11 génère un signal DEC.

Le signal INC incrémente un compteur-décompteur binaire non cyclique 12. Dans la suite de la description, ce compteur-décompteur sera simplement appelé compteur 12. Le signal DEC décrémente le compteur binaire 12. La valeur du compteur 12 est décomposée en deux signaux REG et CTL. Les bits de poids faible constituent suivant un codage approprié, le premier signal REG. Les bits de poids fort constituent suivant le codage approprié, le deuxième signal CTL. Le nombre de bits de poids faible est choisi de façon à coder le nombre de cellules 130,...,134. Dans l'exemple de la figure 1, le nombre de cellules étant de cinq, le nombre de bits de poids faible est de trois de façon à coder cinq valeurs binaires, par exemple suivant l'ordre naturel : 000, 001, 010, 011, 100. Ces valeurs binaires sont les états interne du compteur. Le reste des bits constitue les bits de poids fort.

Le compteur 12 est réalisé de façon à ce que chaque atteinte du nombre N sur les bits de poids faible provoque une remise à zéro de ces bits et génère une retenue qui incrémente la valeur représentée par les bits de poids fort. Lorsque le nombre N de cellules est une puissance de deux, le compteur 12 est un compteur classique. Lorsque le nombre N de cellules n'est pas une puissance de deux comme c'est par exemple le cas de la figure 1, le compteur 12 est modifié de façon évidente pour l'homme du métier. Si le nombre de cellules est de cinq, le circuit combinatoire du compteur 12 est tel qu'avec le code choisi, une incrémentation de la valeur 100 provoque une remise à zéro du bit de poids le plus élevé à un au lieu d'une mise à un du bit de poids le moins élevé et génère une retenue propagée vers les bits de poids fort. A l'inverse lorsque que le compteur décrémente l'état 000 a pour successeur l'état 100.

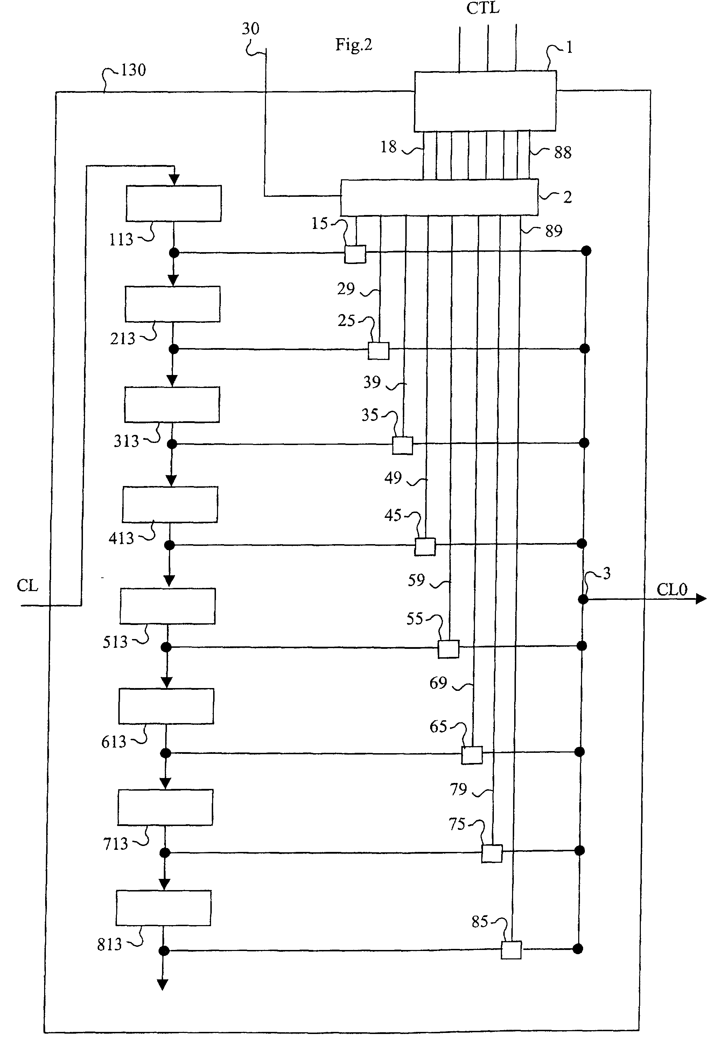

Le signal CTL contrôle directement chacune des cellules 130 à 134 de façon expliquée plus en détail dans la description en référence à la figure 2. Chaque bit du signal CTL est véhiculé sur un conducteur différent. Dans l'exemple de la figure 1, trois bits de poids fort permettent de coder huit valeurs. Pour ne pas surcharger la figure, l'ensemble des conducteurs est représenté par un trait unique barré de trois traits obliques qui indiquent que ce trait comprend trois conducteurs en parallèle.

Le signal REG contrôle indirectement chacune des cellules 130 à 134 de façon expliquée plus en détail dans la description en référence à la figure 2. Les bits du signal REG sont décodés par un circuit combinatoire 14. Le circuit combinatoire 14 génère autant de signaux à un bit qu'il existe de cellules à retard, un signal binaire 30 à destination de la cellule 130, un signal binaire 31 à destination de la cellule 131, un signal binaire 32 à destination de la cellule 132, un signal binaire 33 à destination de la cellule 133, un signal binaire 34 à destination de la cellule 134.

Dans le cas N=5, en fonction des états internes des trois bits de poids faible, le circuit combinatoire 14 élabore cinq signaux REG1, REG2, REG3, REG4, REG5 codés suivant la table de vérité suivante:

| Etat interne | REG1 | REG2 | REG3 | REG4 | REG5 |
|---|---|---|---|---|---|
| 000 | 0 | 0 | 0 | 0 | 0 |
| 001 | 1 | 0 | 0 | 0 | 0 |
| 010 | 1 | 1 | 0 | 0 | 0 |
| 011 | 1 | 1 | 1 | 0 | 0 |
| 100 | 1 | 1 | 1 | 1 | 0 |

En fait seulement N-1 signaux sont significatifs, en effet une remise à zéro du signal REG par incrémentation, provoque une incrémentation du signal CTL par propagation de retenue qui, comme nous le verrons par la suite, provoque le même effet que l'ensemble des signaux REG1 à REG5 à 1 sans incrémentation du signal CTL. Le signal REG5 n'est donc pas nécessairement élaboré.

Comme expliqué dans la suite de la description, le procédé selon l'invention permet de graver des pistes du circuit combinatoire 14 de façon à affecter chacun des signaux REG1, REG2, REG3, REG4 et éventuellement REG5, à l'un des signaux 30, 31, 32, 33, 34.

Au démarrage du circuit représenté en figure 1, la valeur du compteur 12 est à zéro. Comme expliqué plus tard en référence à la figure 2, le signal CTL et le signal REG contrôlent alors une valeur minimale de retard pour chacune des N cellules en cascades 130 à 134. Le retard minimal de chaque cellule est choisi de façon à provoquer un retard de phase du dernier signal CL4 par rapport au signal de référence CL, nettement inférieur à une période de 2π. Le déphasage négatif qui en résulte en entrée du comparateur de phase 11, provoque une incrémentation du compteur 12 jusqu'à ce que sa valeur commande, sur les cellules 130 à 134, un retard dont résulte un déphasage supérieur ou égal à zéro en entrée du comparateur 11. Un déphasage positif en entrée du comparateur 11, provoque une décrémentation du compteur 12.

Lorsque le dernier signal CL4 est en phase avec le signal de référence CL, chacun des signaux CL1 à CL4 est régulièrement déphasé d'une portion quasi identique de période par rapport au signal respectif CL0 à CL3 qui le précède. En récupérant le signal CL0 sur une borne 110, le signal CL1 sur une borne 210, le signal CL2 sur une borne 310, le signal CL3 sur une borne 410, le signal CL4 sur une borne 510, on obtient un multiplieur de fronts de fréquence exactement multiple de la fréquence des fronts du signal CL.

La cellule 130 est expliquée maintenant plus en détail en référence à la figure 2.

La cellule 130 comprend un certain nombre M d'éléments à retard 113, 213, 313, 413, 513, 613, 713, 813. L'élément à retard 113 reçoit en entrée le signal CL. L'élément à retard 213 reçoit en entrée la sortie de l'élément à retard 113. L'élément à retard 313 reçoit en entrée la sortie de l'élément à retard 213. L'élément à retard 413 reçoit en entrée la sortie de l'élément 313. L'élément à retard 513 reçoit en entrée la sortie de l'élément à retard 413. L'élément à retard 613 reçoit en entrée la sortie de l'élément à retard 513. L'élément à retard 713 reçoit en entrée la sortie de l'élément à retard 613. L'élément à retard 813 reçoit en entrée la sortie de l'élément à retard 713. Le signal CL0 est obtenu sur un noeud 3 de la cellule 130. Un interrupteur 15 est connecté entre la sortie de l'élément à retard 113 et le noeud 3. Un interrupteur 25 est connecté entre la sortie de l'élément à retard 213 et le noeud 3. Un interrupteur 35 est connecté entre la sortie de l'élément à retard 313 et le noeud 3. Un interrupteur 45 est connecté entre la sortie de l'élément à retard 413 et le noeud 3. Un interrupteur 55 est connecté entre la sortie de l'élément à retard 513 et le noeud 3. Un interrupteur 65 est connecté entre la sortie de l'élément à retard 613 et le noeud 3. Un interrupteur 75 est connecté entre la sortie de l'élément à retard 713 et le noeud 3. Un interrupteur 85 est connecté entre la sortie de l'élément à retard 813 et le noeud 3.

Un commutateur 2 rend passant un et un seul des interrupteurs 15, 25, 35, 45, 55, 65, 75, 85. Ainsi, selon celui des interrupteurs 15, 25, 35, 45, 55, 65, 75, 85 qui est passant, le signal CL0 obtenu sur le noeud 3 est égal soit, respectivement au signal en sortie de l'élément à retard 113, en sortie de l'élément à retard 213, en sortie de l'élément à retard 313, en sortie de l'élément à retard 413, en sortie de l'élément à retard 513, en sortie de l'élément à retard 613, en sortie de l'élément à retard 713 ou en sortie de l'élément à retard 813.

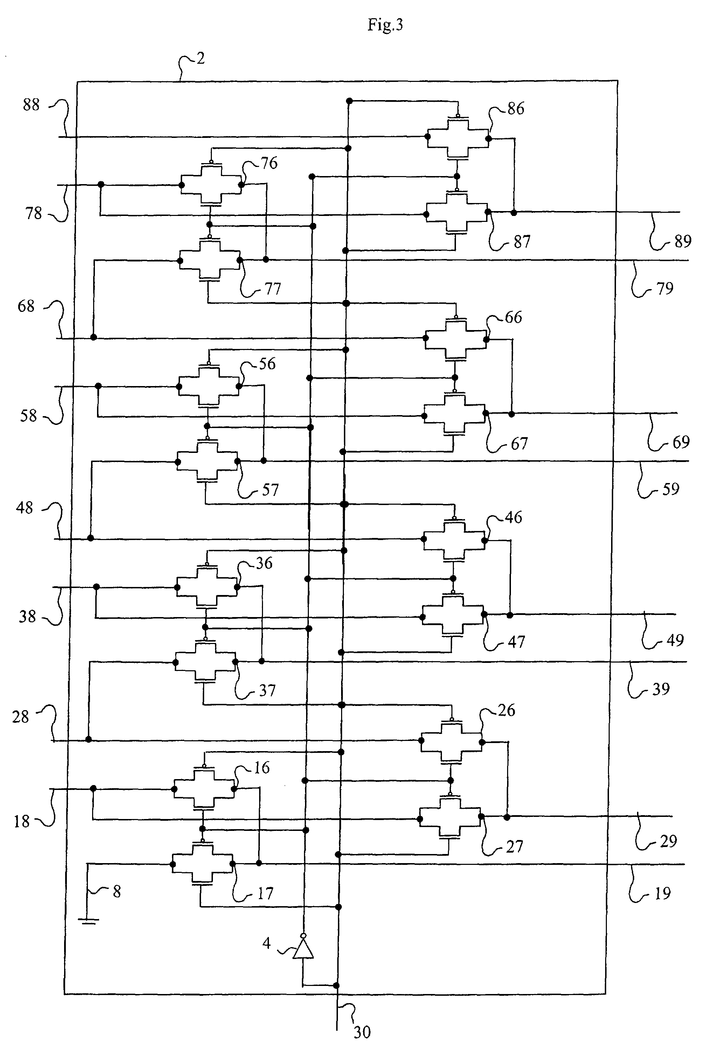

Le commutateur 2 est commandé par le signal 30 comme expliqué maintenant plus en détail en référence à la figure 3. En sortie du commutateur 2, un conducteur 19 est destiné à la commande de l'interrupteur 15, un conducteur 29 est destiné à la commande de l'interrupteur 25, un conducteur 39 est destiné à la commande de l'interrupteur 35, un conducteur 49 est destiné à la commande de l'interrupteur 45, un conducteur 59 est destiné à la commande de l'interrupteur 55, un conducteur 69 est destiné à la commande de l'interrupteur 65, un conducteur 79 est destiné à la commande de l'interrupteur 75, un conducteur 89 est destiné à la commande de l'interrupteur 85. Le conducteur 19 est connecté en aval de deux interrupteurs 16 et 17. Le conducteur 29 est connecté en aval de deux interrupteurs 26 et 27. Le conducteur 39 est connecté en aval de deux interrupteurs 36 et 37. Le conducteur 49 est connecté en aval de deux interrupteurs 46 et 47. Le conducteur 59 est connecté en aval de deux interrupteurs 56 et 57. Le conducteur 69 est connecté en aval de deux interrupteurs 66 et 67. Le conducteur 79 est connecté en aval de deux interrupteurs 76 et 77. Le conducteur 89 est connecté en aval de deux interrupteurs 86 et 87. Le signal 30 commande directement l'état passant des interrupteurs 17, 27, 37, 47, 57, 67, 77, 87. Un état inverse du signal 30, obtenu au moyen d'un inverseur 4, commande l'état passant des interrupteurs 16, 26, 36, 46, 56, 66, 76, 86. Un conducteur 8, raccordé d'une part à la masse, est d'autre part connecté en amont de l'interrupteur 17. Un conducteur 18 est connecté en amont de l'interrupteur 16 et de l'interrupteur 27. Un conducteur 28 est connecté en amont de l'interrupteur 37 et de l'interrupteur 26. Un interrupteur 38 est connecté en amont de l'interrupteur 36 et de l'interrupteur 47. Un conducteur 48 est connecté en amont des interrupteurs 57 et 46. Un conducteur 58 est connecté en amont des interrupteurs 56 et 67. Un conducteur 68 est connecté en amont des interrupteurs 77 et 66. Un conducteur 78 est connecté en amont des interrupteurs 76 et 87. Un conducteur 88 est connecté en amont de l'interrupteur 86. Ainsi, lorsque le signal 30 est à zéro, l'état électrique de chacun des conducteurs 19, 29, 39, 49, 59, 69, 79, 89, est respectivement égal à l'état électrique de chacun des conducteurs 18, 28, 38, 48, 58, 68, 78, 88. Lorsque le signal 30 est à 1, l'état électrique de chacun des conducteurs 19,29, 39, 49, 59, 69, 79, 89, est égal respectivement à l'état électrique de chacun des conducteurs 8, 18, 28, 38, 48, 58, 68, 78.

En référence à la figure 2, un décodeur 1 reçoit en entrée le signal CTL. Chacun des conducteurs 18, 28, 38, 48, 58, 68, 78, 88, est connecté en sortie du décodeur 1. De façon connue le décodeur 1 est agencé pour faire correspondre à chaque valeur du signal CTL, une valeur haute sur un et un seul des conducteurs 18, 28, 38, 48, 58, 68, 78, 88. Ainsi, la valeur nulle du signal CTL correspond à la valeur haute sur le conducteur 18 et à la valeur basse sur les autres conducteurs. La valeur maximale du signal de contrôle CTL correspond à l'état haut sur le conducteur 88 et l'état bas sur tous les autres conducteurs. Lorsque le signal 30 est à zéro, celui des interrupteurs 15, 25, 35, 45, 55, 65, 75, 85 qui est passant, est celui de rang correspondant à la valeur du signal CTL. Lorsque le signal 30 est à un, celui des interrupteurs 15, 25, 35, 45, 55, 65, 75, 85 qui est passant, est celui de rang immédiatement supérieur à la valeur du signal CTL. De cette manière, pour chaque valeur du signal CTL, le signal CL0 obtenu sur le noeud 3, est égal au signal en sortie de celui des éléments à retard 113, 213, 313, 413, 513, 613, 713, 813, de rang identique à la valeur du signal CTL lorsque le signal 30 est à zéro, et de rang immédiatement supérieur lorsque le signal 30 est à un.

Chacune des cellules à retard 131, 132, 133, 134, est identique à la cellule à retard 130. L'explication qui précède en référence à la figure 2, s'applique à la cellule 131 en remplaçant le signal 30 par le signal 31, le signal CL0 par le signal CL1, le signal CL par le signal CL0, s'applique à la cellule 132 en remplaçant le signal 30 par le signal 32, le signal CL0 par le signal CL2, le signal CL par le signal CL1, s'applique à la cellule 133 en remplaçant le signal 30 par le signal 33, le signal CL0 par le signal CL3, le signal CL par le signal CL2, s'applique à la cellule 134 en remplaçant le signal 30 par le signal 34, le signal CL0 par le signal CL4, le signal CL par le signal CL3.

Lorsque tous les signaux 30, 31, 32, 33, 34, sont à zéro, le retard est identique pour toutes les cellules 130, 131, 132, 133, 134. Ce retard résulte directement du signal CTL qui commande un état passant pour le même des interrupteurs 15, 25, ... 85 dans chacune des cellules 130, ... 134. Chaque signal CL0, CL1, ... CL4, est donc obtenu en aval du même nombre d'élément à retard 113, 213, ... 813 dans chaque cellule. Le retard total en sortie de la dernière cellule 134 par rapport à l'entrée de la première cellule 130 est donc équi-répartie entre les sorties de chacune des cellules.

L'invention permet de faire varier le retard total de la chaîne de cellule 130, ... 134 par incréments égaux chacun à un retard élémentaire procuré par un élément à retard 113, ... 813.

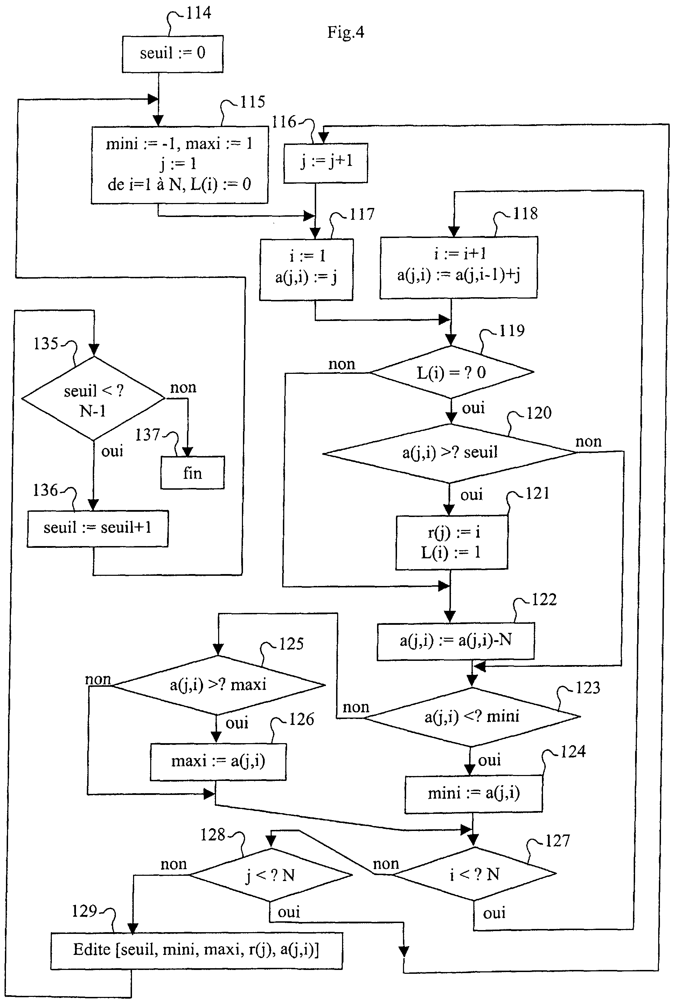

Une augmentation de retard est obtenue en mettant à un, successivement un signal 30, 31, ... 34 dans un ordre déterminé par le procédé expliqué en référence à la figure 4. Une diminution de retard est obtenue en remettant à zéro, successivement un signal 30, ... 34 dans l'ordre inverse.

En référence à la figure 4, le procédé comprend une première boucle d'action représentée par des étapes 116 à 128 où une valeur j varie de 1 à N. La valeur j correspond à un retard supplémentaire en sortie de la chaîne de cellule à retard 130, ... 134, égal à j fois le retard élémentaire. La valeur j est initialisée à 1 dans une étape 115 extérieure à la première boucle. Une action de la première boucle comprend une deuxième boucle d'action représentée par des étapes 118 à 127. La deuxième boucle est successivement parcourue pour des valeurs i variant de 1 à N. La valeur i correspond à un rang de cellule 130,... 134 dans la chaîne de cellule à retard. La valeur i est initialisée à 1 dans une étape 117 extérieure à la deuxième boucle. Dans le schéma de la figure 1, la valeur i =1, représente le rang de la cellule 130. Pour chaque cellule de rang i, une première erreur a (j,i) est calculée dans une étape 118.

La valeur a(j,i) est initialisée à j dans l'étape 117 pour une valeur de i égale à 1. La cellule de rang i=1, est la cellule 130 de la figure 1. Pour obtenir un retard égal à j fois le retard élémentaire en sortie de la dernière cellule 134 de la chaîne qui répartit de façon identique ce retard sur les N cellules de la chaîne, un retard idéal en sortie de la première cellule 130 est égal à j/N fois le retard élémentaire Tₑ. Avant commande d'un retard élémentaire supplémentaire de la cellule 130, la valeur a(j,1) est celle d'une erreur par rapport au retard idéal, dont l'unité est le retard élémentaire divisé par le nombre total N de cellules 130, ..., 134. La convention ici adoptée fait qu'une valeur positive d'erreur correspond à une avance par rapport au signal qui convient.

Avant commande d'un retard élémentaire supplémentaire de chaque cellule suivante de rang i, recevant en entrée un signal de la cellule précédente avec un retard égal à (i-1) fois le retard idéal, la valeur d'erreur a(j,i) est égale à j fois la même unité que pour la cellule 130, c'est à dire le retard élémentaire divisé par le nombre N. Lorsque le retard du signal en sortie de la cellule précédente, est reçu avec une valeur d'erreur a(j,i-1), la valeur d'erreur a(j,i) est donc égale à a(j,i-1)+j.

Dans la deuxième boucle, une étape 118 calcule pour chaque cellule suivante de rang i =i+1, une première valeur d'erreur, conformément au raisonnement du paragraphe précédent.

A la suite d'une activation de l'étape 117, la deuxième boucle commence par une étape 119 qui teste si une valeur L(i) est nulle. Pour tout rang i de cellule de la chaîne de cellules 130, ..., 134, la valeur L(i) est initialisée à zéro dans une étape 115 d'initialisation de la première boucle. Pour chaque cellule de rang i, une valeur L(i) nulle indique qu'aucun retard élémentaire supplémentaire n'est commandé sur cette cellule.

Si le test de l'étape 119 est positif, une étape 120 teste si la première valeur d'erreur calculée avant l'étape 119, est supérieure à un seuil prédéterminé. Nous verrons dans la suite de la description, une possibilité pour déterminer une valeur de seuil.

Si le test de l'étape 120 est positif, une étape 121 donne i pour valeur à une variable r(j). La variable r(j) indique le rang de la cellule pour laquelle est commandée une application de retard élémentaire supplémentaire de façon à obtenir j fois le retard élémentaire en sortie de la chaîne de cellules à retard 130, ..., 134. La valeur i de la variable r(j) vient ainsi compléter un ordre dans lequel est commandée une application de retard élémentaire sur les cellules de la chaîne de cellules à retard 130, ..., 134. De façon à indiquer que la cellule de rang i est retenue pour application de retard élémentaire supplémentaire, la valeur L(i) est mise à 1.

Une étape 122 calcule une deuxième valeur de l'erreur a(i,j) en retranchant N à la première valeur de l'erreur a(j,i). En effet, comme nous l'avons vu précédemment, l'unité de retard idéal sur chaque cellule est égale au retard élémentaire divisé par N. Appliquer un retard élémentaire à la cellule de rang i, revient donc à retrancher N fois le retard idéal de l'erreur a(j,i).

Si le test de l'étape 119 est négatif, cela signifie qu'une application de retard élémentaire à la cellule de rang i, a déjà été commandée pour des valeurs précédentes de j. L'étape 122 est alors directement activée pour tenir compte de l'application de retard élémentaire précédente à cette cellule.

Si le test de l'étape 120 est négatif, l'erreur a(j,i) reste sur la première valeur précédemment calculée dans l'étape 118. Les étapes 121 et 122 sont court-circuitées de façon à activer directement une étape 123.

Le groupe d'étapes 123 à 126 a pour but d'indiquer la plus grande valeur d'erreur nommée ici maxi et la plus petite valeur d'erreur nommée ici mini. Une édition de la valeur de seuil utilisée avec les valeurs minimales et maximales d'erreur, dans une étape 129 en sortie de boucles, permet d'évaluer une influence de la valeur de seuil sur la plage d'erreur [mini, maxi]. Les valeurs mini et maxi sont initialisées dans l'étape 115.

L'étape 123 teste si la valeur d'erreur courante a(j,i) est inférieure à la valeur courante mini. Si le test est positif, la valeur mini est mise à la valeur d'erreur courante dans l'étape 124. Si le test est négatif, l'étape 125 teste si la valeur d'erreur courante a(j,i) est supérieure à la valeur courante maxi. Si le test de l'étape 125 est positif, la valeur maxi est mise à la valeur d'erreur courante dans l'étape 126. Si le test est négatif, l'étape 126 est court-circuitée pour se brancher directement en aval de l'étape 124.

L'étape 127 teste si le rang i est inférieur à N, c'est à dire si le rang i n'est pas celui de la dernière cellule. Si le test est positif, la deuxième boucle est refermée sur l'étape 118 de façon à exécuter les étapes 118 à 127 pour une valeur i=i+1 suivante. Si le test est négatif, le rang i est celui de la dernière cellule 134 de la chaîne de N cellules. Un retard élémentaire ayant été appliqué sur une cellule de rang r(j), l'erreur a(j,N) est nulle. Le test négatif de l'étape 127 fait sortir le procédé de la deuxième boucle pour exécuter l'étape 128 de la première boucle.

L'étape 128 teste si la valeur j est inférieure à N. Si le test est positif, la première boucle est refermée sur l'étape 116 de façon à exécuter les étapes 116 à 128 pour une valeur j=j+1 suivante. Si le test est négatif, j=N. Le retard supplémentaire en sortie de la chaîne est égal à N fois le retard élémentaire Tₑ, chacune des cellules est commandée pour générer un retard supplémentaire égal au retard élémentaire Tₑ. Le test négatif de l'étape 128 fait sortir le procédé de la première boucle pour exécuter l'étape 129.

L'étape 129 édite pour chaque valeur de j, le rang r(j) de la chaîne de cellules 130,..., 134. La suite des valeurs r(j) pour j variant de 1 à N, détermine un ordre de cellules à retarder avec le retard élémentaire Tₑ lorsque le retard supplémentaire en sortie de chaîne évolue du retard élémentaire Tₑ à N fois le retard élémentaire Tₑ. Une exécution progressive de l'étape 129 avant l'étape 128 donne le même résultat. Comme expliqué par la suite, l'ordre de cellules à retarder est utilisé pour réaliser le circuit combinatoire 14.

La valeur du seuil utilisée de façon prédéterminée dans l'étape 120, est déterminée de façon avantageuse, automatiquement au moyen d'une troisième boucle extérieure à la première boucle. La troisième boucle fait varier la valeur de seuil d'une valeur initialisée à zéro dans une étape 114, à une valeur N-1 contrôlée dans une étape 135 qui termine le procédé en étape 137 lorsque la valeur de seuil atteint la valeur N-1. En effet, rappelons que l'unité de retard dans la première boucle, est égale à Tₑ /N. Une valeur maximale du seuil égale à N-1 en unité de retard de la première boucle, permet de faire une correction sur une cellule de rang i dès que l'erreur est supérieure à Tₑ *(N-1)/N, c'est à dire dès que l'erreur atteint la valeur de retard élémentaire Tₑ.

Dans la troisième boucle, l'étape 129 édite alors l'ordre constitué des rangs r(j), j variant de 1 à N, pour la valeur de seuil courante. Après l'étape 129, l'étape 135 teste si le seuil est inférieur à N-1. Un test positif déclenche une étape 136 qui incrémente la valeur de seuil avant de déclencher l'étape 115 qui active alors la première boucle avec la nouvelle valeur de seuil. Le premier déclenchement de l'étape 115 suit l'étape 114. Un test négatif déclenche l'étape de fin 137.

Les valeurs de seuil, d'erreurs mini, maxi et l'ordre r(j)₁^{N}, éditées à chaque passage par l'étape 129, permettent de choisir pour la réalisation du circuit combinatoire 14, l'ordre r(j)₁^{N} qui donne des erreurs mini, maxi acceptables. Une information supplémentaire est obtenue lorsque l'étape 129 édite sous forme de tableau, les erreurs a(j,i) qui résultent de la première boucle. Cette information supplémentaire peut éventuellement servir à orienter le choix lorsque plusieurs choix équivalents sont présentés par la troisième boucle.

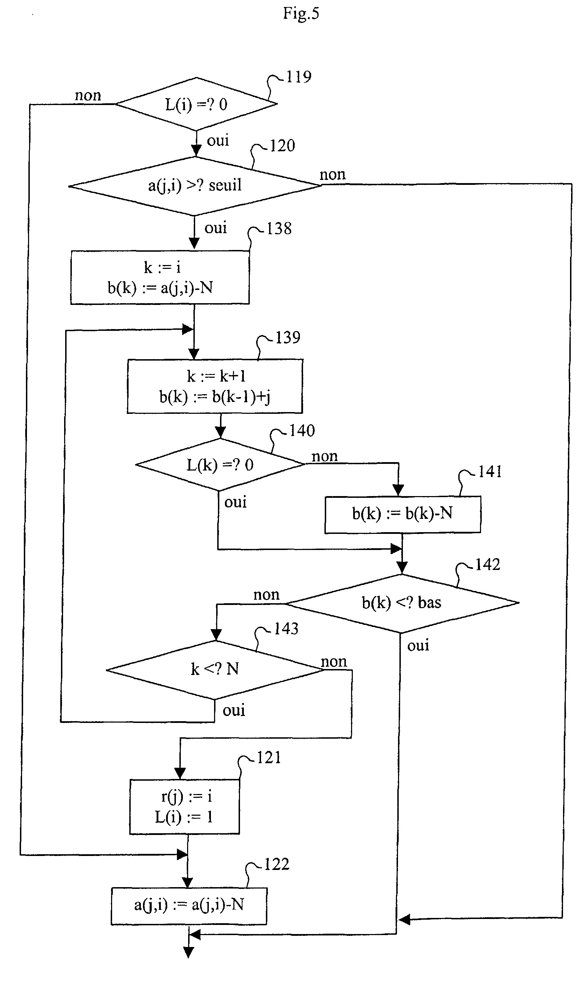

La figure 5 présente des étapes supplémentaires 138 à 143 qui, insérées entre les étapes 120 et 121, permettent d'éviter que l'erreur descende en dessous d'un niveau négatif trop bas, suite à une correction sur la cellule de rang i.

En effet, l'ordre défini par le procédé n'est pas un ordre successif de la première à la dernière cellule. En appliquant le retard élémentaire à la cellule de rang i, il se peut donc qu'un retard élémentaire ait été appliqué précédemment à une ou plusieurs cellules de rang k supérieur à i.

Les étapes 139 à 143 constituent une quatrième boucle qui évalue une troisième valeur d'erreur b(k) pour des rangs k de cellules qui suivent le rang i de la cellule considérée dans la deuxième boucle.

L'étape 138 initialise la quatrième boucle avec une valeur de k égale à la valeur i courante et la troisième valeur d'erreur b(k) avec la deuxième valeur d'erreur qui résulte pour la cellule de rang i si l'étape 122 est exécutée.

L'étape 139 incrémente ensuite la valeur de k et pour chaque rang k de cellule, calcule l'erreur b(k) résultante, de façon identique à l'étape 118.

L'étape 140 vérifie si un retard élémentaire n'a pas déjà été appliqué à la cellule de rang k. Aucun retard élémentaire n'a été appliqué à la cellule de rang k pour des valeurs de j inférieure à la valeur courante de j si L(k)=0. Un résultat négatif au test de l'étape 140 déclenche l'étape 141 pour tenir compte du retard élémentaire Tₑ, précédemment appliqué à la cellule de rang k. De façon identique à l'étape 122, l'étape 141 retranche de l'erreur b(k) la valeur N, c'est à dire N fois le N^{ième} de retard élémentaire Tₑ réparti de façon équitable sur les N cellules.

Un résultat positif au test de l'étape 140 court-circuite l'étape 141 de façon à laisser l'erreur sur la première valeur b(k) calculée en étape 139.

L'étape 142 teste ensuite si la valeur d'erreur b(k) est inférieure à une valeur prédéterminée nommée bas.

Un résultat positif au test de l'étape 142 fait directement sortir le procédé de la quatrième boucle, en aval de l'étape 122. Ceci a le même effet qu'un résultat négatif au test de l'étape 120. C'est à dire que le retard élémentaire n'est pas appliqué à la cellule de rang i. L'erreur en sortie de la cellule de rang i, reste sur la première valeur calculée en étape 118.

La valeur bas peut être par exemple, prédéterminée égale à la valeur 1-N. La quatrième boucle évite alors que l'erreur en sortie de cellules de rang k supérieur au rang i, descende en dessous d'une valeur négative, égale à 1-N. La deuxième boucle se poursuivant pour les valeurs de i suivante, le retard supplémentaire sera appliqué à une autre cellule. Pour de grandes valeurs de N, il est possible de choisir des valeurs plus basses de bas.

Un résultat négatif au test de l'étape 142 active l'étape 139 tant que k est inférieur à N. Lorsque k atteint la valeur N, le procédé sort de la quatrième boucle pour activer l'étape 121 de façon identique à ce qui est décrit en référence à la figure 4.
La quatrième boucle n'est pas indispensable mais elle assure que l'erreur en sortie d'une cellule quelconque de la chaîne, ne descend pas en dessous d'une valeur négative prédéterminée lorsque le retard élémentaire Tₑ est appliqué à la cellule de rang i.

Comme expliqué précédemment, le procédé permet d'éditer plusieurs ordres r(j), j variant de 1 à N, chacun pour une valeur de seuil prédéterminée. Une édition des erreurs minimale et maximale pour chaque seuil permet alors de choisir l'ordre qui minimise les erreurs.

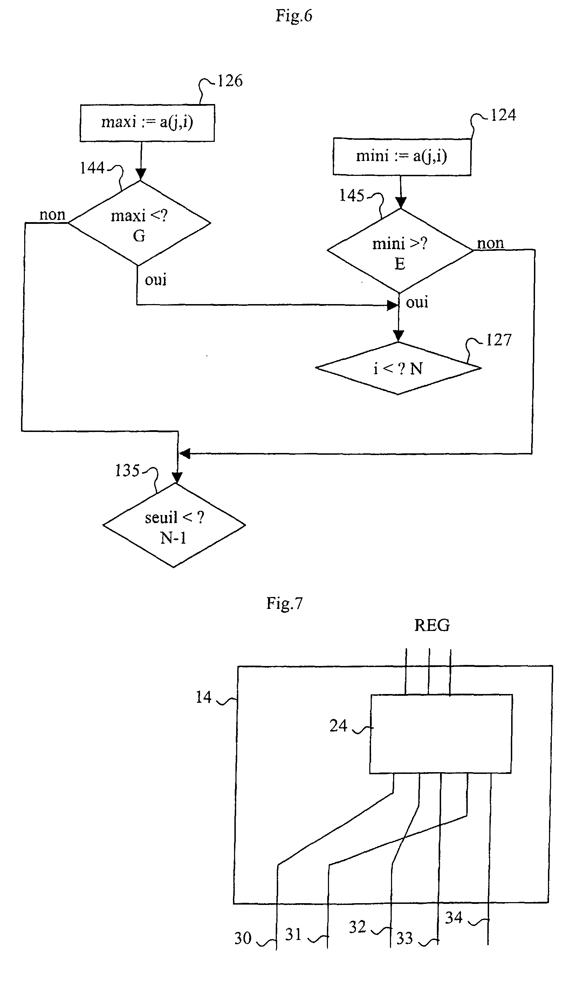

Le procédé est encore amélioré par insertion d'étapes 144 et 145, telles que décrites maintenant en référence à la figure 6.

L'étape 144 est insérée entre l'étape 126 et l'étape 127. L'étape 144 teste si la valeur maxi déterminée en étape 126 est inférieure à une valeur G. Un résultat positif active l'étape 127 comme dans le procédé de base expliqué en référence à la figure 4.

Un résultat négatif au test de l'étape 144 fait directement sortir le procédé de la première boucle en activant l'étape 135. Ainsi, lorsque la valeur maxi d'erreur est supérieure à G, l'ordre r(j) et le seuil correspondant ne sont pas édités en étape 129.

La valeur de G est par exemple prise égale à N-1. Ceci assure que l'erreur en sortie d'une cellule ne dépasse pas (N-1) fois le retard élémentaire Tₑ/N, c'est à dire que l'erreur est inférieure au retard élémentaire Tₑ.

L'étape 145 est insérée entre l'étape 124 et l'étape 127. L'étape 145 teste si la valeur mini déterminée en étape 124 est supérieure à une valeur E. Un résultat positif active l'étape 127 comme dans le procédé de base expliqué en référence à la figure 4.

Un résultat négatif au test de l'étape 145 fait directement sortir le procédé de la première boucle en activant l'étape 135. Ainsi, lorsque la valeur mini d'erreur est inférieure à E, l'ordre r(j) et le seuil correspondant ne sont pas édités en étape 129.

La valeur de E est par exemple prise égale à 1-N. Ceci assure que l'erreur en sortie d'une cellule ne descend pas en dessous d'une valeur négative égale à (N-1) fois le retard élémentaire Tₑ/N, c'est à dire que l'erreur négative est inférieure en valeur absolue au retard élémentaire Tₑ.

Ceci est particulièrement avantageux pour les grandes valeurs de N car la non édition d'ordres qui donnent des erreurs à priori écartées, facilite l'étude des résultats.

Si pour certaines valeurs de N, la limitation de l'erreur entre -Tₑ et +Tₑ, est trop contraignante, au point de ne donner l'édition d'aucun résultat, il est possible d'augmenter la valeur de G et/ou de diminuer la valeur de E, par exemple respectivement à +N et à -N. Chaque augmentation de G et chaque diminution de E, d'une unité, n'augmente l'erreur en valeur absolue que du retard élémentaire Tₑ divisé par N.

L'annexe 1 donne un exemple de résultat édité dans l'étape 129 pour N = 5. On y observe que pour un seuil égal à zéro, l'erreur maximale positive maxi est égale à 1 et l'erreur maximale négative mini est égale à -4. Les plus petites plages d'erreur sont obtenues pour seuil = 0 et pour seuil = 4.

Le choix d'un ordre parmi les résultats obtenus permet de réaliser le circuit 14. Supposons que l'ordre choisi soit celui correspondant à seuil = 0. La figure 7 présente alors le circuit réalisé pour appliquer le retard élémentaire Tₑ dans l'ordre trouvé : 1, 3, 4, 2, 5.

Le circuit combinatoire 14 reçoit en entrée le signal REG dont le bit de poids le plus faible est ici représenté à gauche. Le circuit combinatoire 14 comprend un composant combinatoire 24 qui élabore de façon connue au moyen de portes logique les signaux REG1, REG2, REG3, REG4, REG5 conformément à la table de vérité précédemment expliquée pour N = 5.

De façon à appliquer le retard élémentaire Te aux cellules 130, 131, 132, 133, 134, dans l'ordre qui résulte du procédé pour un seuil égal à zéro, le signal REG1 est acheminé sur une sortie du circuit 14 qui correspond au signal 30, le signal REG2 est acheminé sur une sortie du circuit 14 qui correspond au signal 32, le signal REG3 est acheminé sur une sortie du circuit 14 qui correspond au signal 33, le signal REG4 est acheminé sur une sortie du circuit 14 qui correspond au signal 31. Le signal REG5 est acheminé sur une sortie du circuit 14 qui correspond au signal 34. Le signal REG5 étant toujours à zéro, n'est pas nécessairement câblé sur cette dernière sortie.

Ainsi, lorsque le signal REG est à zéro, les cellules 130 à 134 ont toutes un même retard de départ commandé par le signal CTL. Lorsque le signal REG est à un, un retard élémentaire supplémentaire est appliqué à la cellule 130. Lorsque le signal REG est à deux, le retard élémentaire supplémentaire est appliqué aux cellules 130 et 132. Lorsque le signal REG est à trois, le retard élémentaire supplémentaire est appliqué aux cellules 130, 132 et 133. Lorsque le signal REG est à quatre, le retard élémentaire supplémentaire est appliqué aux cellules 130, 132, 133 et 131. Lorsque le signal REG dépasse la valeur quatre, il est remis à zéro et le signal CTL est incrémenté d'une unité, ce qui a pour effet d'ajouter au retard de départ, le retard élémentaire appliqué à chacune des cellules 130, 132, 133, 131 et 134. Le cycle se poursuit jusqu'à ce que le signal CL4 soit en phase avec le signal CL.

L'erreur commise en sortie de chaque cellule par rapport à un retard idéal équiréparti sur toutes les cellules, est toujours inférieure à la valeur de retard élémentaire Tₑ.

### Annexe 1

### NOMBRE DE RETARDS = 5

| Tableau des Ecarts AVant Correction sur un Cycle de Réglage (en Tₑ/5) | | | | |
|---|---|---|---|---|
| 1 | 2 | 3 | 4 | 5 |
| 2 | 4 | 6 | 8 | 10 |
| 3 | 6 | 9 | 12 | 15 |
| 4 | 8 | 12 | 16 | 20 |
| 5 | 10 | 15 | 20 | 25 |

Pour un seuil de =0 on a :
erreur maxi en positif = 1
erreur maxi en négatif = -4

L ordre trouve: =====>>> 1 3 4 2 5 <<< =====

| tableau des erreurs résiduelles: | | | | |
|---|---|---|---|---|
| -4 | -3 | -2 | -1 | 0 |
| -3 | -1 | -4 | -2 | 0 |
| -2 | 1 | -1 | -3 | 0 |
| -1 | -2 | -3 | -4 | 0 |
| 0 | 0 | 0 | 0 | 0 |

Pour un seuil de =1 on a :
erreur maxi en positif = 2
erreur maxi en négatif = -4

L ordre trouve: =====>>> 2 4 1 3 5 <<< =====

| tableau des erreurs résiduelles: | | | | |
|---|---|---|---|---|
| 1 | -3 | -2 | -1 | 0 |
| 2 | -1 | 1 | -2 | 0 |
| -2 | -4 | -1 | -3 | 0 |
| -1 | -2 | -3 | -4 | 0 |
| 0 | 0 | 0 | 0 | 0 |

Pour un seuil de =2 on a :
erreur maxi en positif = 3
erreur maxi en négatif = -4

L ordre trouve: =====>>> 3 2 5 1 4 <<< =====

| tableau des erreurs résiduelles: | | | | |
|---|---|---|---|---|
| 1 | 2 | -2 | -1 | 0 |
| 2 | -1 | -4 | -2 | 0 |
| 3 | 1 | -1 | 2 | 0 |
| -1 | -2 | -3 | 1 | 0 |
| 0 | 0 | 0 | 0 | 0 |

Pour un seuil de =3 on a :
erreur maxi en positif = 3
erreur maxi en négatif = -4

L ordre trouve: =====>>> 4 2 3 1 5 <<< =====

| tableau des erreurs résiduelles: | | | | |
|---|---|---|---|---|
| 1 | 2 | 3 | -1 | 0 |
| 2 | -1 | 1 | -2 | 0 |
| 3 | 1 | -1 | -3 | 0 |
| -1 | -2 | -3 | -4 | 0 |
| 0 | 0 | 0 | 0 | 0 |

Pour un seuil de =4 on a :
erreur maxi en positif = 4
erreur maxi en négatif = -1

L ordre trouve: =====>>> 5 3 2 4 1 <<< =====

| tableau des erreurs résiduelles: | | | | |
|---|---|---|---|---|
| 1 | 2 | 3 | 4 | 0 |
| 2 | 4 | 1 | 3 | 0 |
| 3 | 1 | -1 | 2 | 0 |
| 4 | 3 | 2 | 1 | 0 |
| 0 | 0 | 0 | 0 | 0 |

## Revendications

1. Procédé pour déterminer un ordre de cellules à retarder dans une chaîne de N cellules à retard (130, 131, 132, 133, 134), rebouclée en phase, **caractérisé en ce qu'**il comprend:
- une première boucle d'actions (116,..., 128) pour des valeurs j variant de 1 à N, chacune correspondante à un retard total égal à j fois un retard élémentaire (Tₑ) d'une cellule, à appliquer à la chaîne de N cellules à retard, une action de la première boucle comprenant:
- une deuxième boucle d'actions (118, ..., 127) pour des valeurs i variant de 1 à N, chacune correspondante à un rang de cellule de ladite chaîne, une action de la deuxième boucle calculant une erreur (a(j,i)) de retard en sortie de la cellule de rang i par rapport à un retard idéal qui équirépartit le retard total de la chaîne sur chaque cellule, de façon à ce que:
- une première valeur de ladite erreur est calculée avant commande d'un retard élémentaire (Tₑ) supplémentaire de la cellule de rang i;
- une deuxième valeur de ladite erreur est calculée si la première valeur est supérieure à un seuil prédéterminé, après commande d'un retard élémentaire supplémentaire de ladite cellule de rang i, ledit rang i complétant alors ledit ordre à déterminer.

2. Procédé pour déterminer un ordre de cellules à retarder selon la revendication 1, **caractérisé en ce qu'**il comprend une troisième boucle d'actions qui active la première boucle d'actions pour chaque valeur de seuil prédéterminé avec une valeur variant de zéro à N-1.

3. Procédé pour déterminer un ordre de cellules à retarder selon la revendication 2, **caractérisé en ce que** la deuxième boucle d'actions comprend une quatrième boucle d'actions qui vérifie qu'aucune première valeur d'erreur pour des rangs k de cellules supérieurs au rang i, ne descende en dessous d'une valeur (bas), avant de compléter ledit ordre à déterminer par ledit rang i.

4. Procédé pour déterminer un ordre de cellules à retarder selon l'une des revendications précédentes, **caractérisé en ce qu'**il comprend des étapes (123-126) qui calculent une valeur minimale (mini) et une valeur maximale (maxi) d'erreur pour une valeur de seuil prédéterminé.

5. Procédé pour déterminer un ordre de cellules à retarder selon la revendication 4, **caractérisé en ce qu'**il comprend une étape (129) qui édite le seuil, les valeurs minimales et maximales d'erreur ainsi que l'ordre déterminé en sortie de la première boucle.

6. Procédé pour déterminer un ordre de cellules à retarder selon la revendication 5, **caractérisé en ce que** l'étape (129) édite aussi les valeurs d'erreur a(j,i).

## Patentansprüche

1. Verfahren zum Bestimmen einer Reihenfolge von zu verzögernden Zellen in einer Kette aus N Verzögerungszellen (130, 131, 132, 133, 134) mit zurückgeschleifter Phase, **dadurch gekennzeichnet, dass** es umfasst:
- eine erste Schleife von Aktionen (116, ..., 128) für Werte j, die von 1 bis N laufen, wobei jede einer Gesamtverzögerung entspricht, die gleich einer j-fachen Elementarverzögerung (Te) einer Zelle ist und an die Kette aus N Verzögerungszellen anzulegen ist, wobei eine Aktion der ersten Schleife umfasst:
- eine zweite Schleife von Aktionen (118, ..., 127) für Werte i, die von 1 bis N laufen, wobei jede einem Zellenrang der Kette entspricht, wobei eine Aktion der zweiten Schleife einen Verzögerungsfehler (a(j, i)) am Ausgang der Zelle mit Rang i in Bezug auf eine ideale Verzögerung, die die Gesamtverzögerung der Kette auf jede Zelle gleichmäßig verteilt, berechnet, derart, dass:
- ein erster Wert des Fehlers berechnet wird, bevor eine zusätzliche Elementarverzögerung (Tₑ) der Zelle mit Rang i befohlen wird;
- ein zweiter Wert des Fehlers berechnet wird, falls der erste Wert größer als ein vorgegebener Schwellenwert ist, nachdem eine zusätzliche Elementarverzögerung der Zelle mit Rang i befohlen worden ist, wobei der Rang i dann die zu bestimmende Reihenfolge vervollständigt.

2. Verfahren zum Bestimmen einer Reihenfolge von zu verzögernden Zellen nach Anspruch 1, **dadurch gekennzeichnet, dass** es eine dritte Schleife von Aktionen umfasst, die die erste Schleife von Aktionen für jeden vorgegebenen Schwellenwert, wobei der Wert von null bis N - 1 läuft, aktiviert.

3. Verfahren zum Bestimmen einer Reihenfolge von zu verzögernden Zellen nach Anspruch 2, **dadurch gekennzeichnet, dass** die zweite Schleife von Aktionen eine vierte Schleife von Aktionen umfasst, die verifiziert, dass kein erster Fehlerwert für Zellenränge k, die größer als der Rang i sind, unter einen Wert (bas) abfällt, bevor die zu bestimmende Reihenfolge durch den Rang i vervollständigt worden ist.

4. Verfahren zum Bestimmen einer Reihenfolge von zu verzögernden Zellen nach einem der vorhergehenden Ansprüche, **dadurch gekennzeichnet, dass** es die Schritte (123-126) umfasst, die einen minimalen Fehlerwert (mini) und einen maximalen Fehlerwert (maxi) für einen vorgegebenen Schwellenwert berechnen.

5. Verfahren zum Bestimmen einer Reihenfolge von zu verzögernden Zellen nach Anspruch 4, **dadurch gekennzeichnet, dass** es einen Schritt (129) umfasst, der den Schwellenwert, den minimalen und den maximalen Fehlerwert sowie die am Ausgang der ersten Schleife bestimmte Reihenfolge bearbeitet.

6. Verfahren zum Bestimmen einer Reihenfolge von zu verzögernden Zellen nach Anspruch 5, **dadurch gekennzeichnet, dass** der Schritt (129) auch die Fehlerwerte a(j, i) bearbeitet.

## Claims

1. Method for determining an order of cells to be delayed in a chain of N phase-looped delay cells (130, 131, 132, 133, 134), **characterised in that** it comprises:
- a first loop of actions (116, ..., 128) for values j varying from 1 to N, each corresponding to a total delay equal to j times an elementary delay (Tₑ) of a cell, to be applied to the chain of N delay cells, an action of the first loop comprising:
- a second loop of actions (118, ..., 127) for values i varying from 1 to N, each corresponding to a rank of a cell in said chain, an action in the second loop calculating a delay error (a (j, i)) output from the cell of rank i relative to an ideal delay that equally distributes the total delay of the chain over each cell, so that:
- a first value of said error is calculated before the command for an additional elementary delay (Tₑ) of the cell of rank i;
- a second value of said error is calculated if the first value is greater than a predetermined threshold, after the command for an additional elementary delay of said cell of rank i, said rank i then completing said order to be determined.

2. Method for determining an order of cells to be delayed according to Claim 1, **characterised in that** it comprises a third loop of actions that activates the first loop of actions for each predetermined threshold value with a value varying from zero to N-1:

3. Method for determining an order of cells to be delayed according to Claim 2, **characterised in that** the second loop of actions comprises a fourth loop of actions that checks that no first value of error, for cell ranks k higher than the rank i, falls below a (low) value, before the completion of said order to be determined by said rank i.

4. Method for determining an order of cells to be delayed according to one of the preceding claims, **characterised in that** it comprises steps (123-126) that calculate a minimum error value (mini) and a maximum error value (maxi) for a predetermined threshold value.

5. Method for determining an order of cells to be delayed according to Claim 4, **characterised in that** it comprises a step (129) that edits the threshold, the minimum and maximum error values, and the order determined at the output of the first loop.

6. Method for determining an order of cells to be delayed according to Claim 5, **characterised in that** step (129) also edits the error values a(j, i).
